# EUROPÄISCHE PATENTANMELDUNG

(11) **EP 4 197 663 A1**
(43) Veröffentlichungstag der Anmeldung: **21.06.2023**
(21) Anmeldenummer: 22153147.8
(22) Anmeldetag: 25.01.2022
(51) Int. Cl.: B09B 3/35, A43B 13/02

(54) **VERFAHREN UND VORRICHTUNG FÜR DAS RECYCLING VON BEDARFSGEGENSTÄNDEN, INSBESONDERE SCHUHEN UND EINEN FÜR EIN SOLCHES RECYCLING VORBEREITETEN BEDARFSGEGENSTAND**

(30) Priorität: 15.12.2021 EP 21214726
(71) Anmelder: Prüf- und Forschungsinstitut Pirmasens e.V., 66953 Pirmasens (DE)
(72) Erfinder: SCHULTHEIS, Peter, 66871 Pfeffelbach (DE); SCHEIDLER, Romain, 57720 Walschbronn (FR)
(74) Vertreter: Patentanwälte Dr. Keller, Schwertfeger Partnerschaft mbB

(57) **Zusammenfassung**

Die vorliegende Erfindung betrifft ein Verfahren zum Recycling von Bedarfsgegenständen (11), die zumindest teilweise aus flächenhaft verbundenen Materialkomponenten (33, 34) aufgebaut sind, durch Zerlegen der Bedarfsgegenstände (11) in einzelne Materialkomponenten oder Komponentengruppen, wobei zur Trennung der Materialkomponenten des Bedarfsgegenstands ein längliches Schneidelement (12) bereitgestellt wird, gekennzeichnet durch die Schritte:
- Kopplung des Schneidelements (12) mit einer Trenneinrichtung (21), die zur Führung des Schneidelements (12) entlang einer vordefinierten Schnittlinie (13) ausgelegt ist,
- Bewegen des Schneidelements (12) in Schnittrichtung entlang der Schnittlinie (13) quer zur Längsachse (16) des Schneidelements (12), wobei eine linienförmige Trennung in den Verbindungsebenen der flächenhaft verbundenen Materialkomponenten (33, 34) erfolgt,
- Abtrennen der Materialkomponenten entlang der durch die Schnittlinie (13) entstehenden Trennfläche.

Die Erfindung betrifft ferner eine Vorrichtung zur Durchführung eines solchen Verfahrens und einen Bedarfsgegenstand (11) mit integriertem Schneidelement (12).

## Beschreibung

Die vorliegende Erfindung betrifft ein Verfahren und eine Vorrichtung zum Wiederaufbereiten und Wiederverwerten von Bedarfsgegenständen, deren Komponenten und Materialien, insbesondere von Schuhen. Die Erfindung betrifft ferner einen für ein solches Recycling vorbereiteten Bedarfsgegenstand, insbesondere einen Schuh.

Bedarfsgegenstände im weitesten Sinne sind Gegenstände des täglichen Bedarfs und bestehen in der Regel aus Materialverbünden, d.h. aus Materialkomponenten, die aus unterschiedlichen Stoffzusammensetzungen oder Materialien aufgebaut sind und unmittelbar zu einem Produkt verbunden sind. Häufig handelt es sich um flächig zusammengesetzte Materialverbünde, die untrennbar miteinander im Produkt verbunden sind. Die Komponenten werden im Rahmen des Herstellungsprozesses häufig durch Kleben, Schweißen oder Vernähen zusammengefügt. Beispiele solcher Bedarfsgegenstände sind Schuhe.

Unter Recycling versteht man die Aufbereitung und Wiederverwertung von verbrauchten Erzeugnissen. Das Ziel eines Recyclings ist es, die Erzeugnisse, Komponenten der Erzeugnisse und deren Materialien wieder zu verwerten. Zum Wiederverwerten der Materialien müssen die Erzeugnisse möglichst sortenrein aufgetrennt werden. Bedarfsgegenstände, wie Schuhe, am Ende eines Lebenszyklus effizient zu recyceln erweist sich durch die als untrennbare Verbindungen ausgelegten Fügestellen regelmäßig als schwierig. Ein Ansatz im Stand der Technik ist es, die zu recycelnden Gegenstände zunächst zu zerspanen (beispielsweise durch Schreddern) und dann nach Standardmethoden die Materialfraktionen zu trennen und zu sammeln. Diese Verfahren sind jedoch sehr energieintensiv und auch nicht für alle Bedarfsgegenstände geeignet. So bereiten beispielsweise Sicherheitsschuhe mit Stahlkappen beim Schreddern größere Schwierigkeiten. Demgegenüber bietet eine Zerlegung von Produkten am Lebensende in die einzelnen Komponenten und Bestandteile meist energetische Vorteile und eine deutlich verbesserte Recyclingfähigkeit und damit überhaupt erst die Möglichkeit, Komponenten wieder zu verwenden.

Zwar werden für chemische und physikalische Prüfungen von Bedarfsgegenständen schon jetzt Materialproben entnommen bzw. an den Gegenständen zerstörende Prüfungen durchgeführt. Allerdings werden auch hier energetisch aufwändige Trennverfahren wie z.B. Schneiden, Sägen oder Stanzen eingesetzt. Bei solchen im Labor durchgeführten Materialprüfungen liegt der Fokus jedoch nicht auf einem möglichst vollständigen Zerlegen in die einzelnen Komponenten für ein späteres Recycling, sondern auf die Gewinnung ausreichend großer Probenkörper, beispielsweise für Schadstoffprüfungen oder für das Erfassen von Spannungs- oder Dehnungskurven.

Prinzipiell sind im Stand der Technik bereits Verfahren und Vorrichtungen bekannt, die geeignet sind, Bedarfsgegenstände aufzuschneiden bzw. zu trennen.

Ein Verfahren zum Zerkleinern von Schuhen durch eine Zerkleinerungseinrichtung ist beispielsweise in der DE 102010049277 A1 beschrieben. Nach Einbringen der ganzen Schuhe in den Vorratstank werden sie von den unterschiedlich schnell rotierenden Schneckenmessern zerhäckselt und gelangen dann in eine Transportrinne, von wo sie einem Recyclingkreislauf zugeführt werden.

Die DE 102012211026 A1 beschreibt eine Schneidvorrichtung zum Schneiden eines Gegenstands in Schneidrichtung mit einem quer zur Schneidrichtung gespannten und in Schneidrichtung verschiebbaren Schneiddraht. Sie umfasst einen Halterahmen zum Halten des Gegenstands, einen am Halterahmen angebrachten Führungsrahmen zum Spannen des Drahts quer zur Schneidrichtung und zum Führen des gespannten Drahts in Schneidrichtung, und eine Betätigungseinrichtung zum Bewegen des gespannten Drahts in Schneidrichtung.

Die EP 0180107 A2 beschreibt eine Schneidvorrichtung mit einem beheizten Schneiddraht, der in und außer Kontakt mit dem zu schneidenden Material bringbar ist. Die Schneidvorrichtung ist durch doppeltwirkende Führungszylinder horizontal vor und zurück verschiebbar und an Führungen befestigt, die entlang vertikaler Führungsstangen durch eine Positioniervorrichtung auf und ab verfahrbar sind.

Die WO 9808406 A1 beschreibt eine Vorrichtung zur Bearbeitung von Schuhen, insbesondere zum Schneiden von Sohlen und Absätzen. Die Vorrichtung umfasst eine Grundplatte, auf der eine Aufspannvorrichtung für einen Schuh angebracht ist und eine motorisch angetriebene Schneideinrichtung, die an der Grundplatte in Führungen bewegbar gelagert ist, wobei die Lauffläche eines auf die Aufspannvorrichtung aufgespannten Schuhes von der Grundplatte aus gesehen nach außen gerichtet ist und das Schneidwerkzeug der Schneideinrichtung längs durch die Sohle bzw. den Absatz des Schuhes führbar ist.

Dies beschriebenen Verfahren oder Vorrichtungen eignen sich zwar für das Zerkleinern Bedarfsgegenständen, sie sind jedoch nicht dafür ausgelegt, flächig zusammenhängende

Materialverbünde zu trennen. Denn bei vielen Bedarfsgegenständen, insbesondere bei Schuhen, hat man ein besonderes Problem. Laufsohlen aus Kunststoff werden nämlich entweder an den Schuh geklebt oder im Direktbesohlungsverfahren an den Schuh angespritzt. Durch diesen Materialverbund kann die Verbindung zwischen Laufsohle zu Schuhoberteil bzw. zur Brandsohle, unabhängig von der Machart, nicht einfach nur gewaltsam abgezogen werden, wenn eine möglichst materialsortenreine Trennung erfolgen und die Materialien weitgehend als ganze Materialkomponenten erhalten bleiben sollen. Dafür müssten die Verbindungsmechanismen reversibel gestaltet werden, d.h. schon von vorneherein so geplant werden, dass diese später wieder leicht trennbar sind. Solche reversiblen Verbindungen im Materialverbund sind jedoch aus unterschiedlichen Gründen bei Bedarfsgegenständen nicht vorgesehen.

Vor diesem Hintergrund ist es Aufgabe der vorliegenden Erfindung, ein verbessertes Verfahren und eine Vorrichtung zum Recycling von Bedarfsgegenständen, insbesondere von Schuhen, bereitzustellen, die aus zumindest teilweise flächenhaft verbundenen Materialkomponenten bestehen und für eine spätere Wiederverwertung in einzelne Materialkomponenten oder Komponentengruppen zerlegt werden sollen.

Diese Aufgabe wird gelöst durch ein Verfahren mit den Merkmalen des Anspruchs 1 und einer Vorrichtung mit den Merkmalen des Anspruchs 8. Ferner wird erfindungsgemäß ein Bedarfsgegenstand, insbesondere ein Schuh bereitgestellt, der bereits für eine Anwendung beim erfindungsgemäßen Verfahren oder bei der erfindungsgemäße Vorrichtung so vorbereitet ist, dass eine gezielte Trennung der Materialkomponenten des Schuhs ermöglicht wird. Bevorzugte Ausführungsvarianten der Erfindung finden sich in den Unteransprüchen wieder.

Das erfindungsgemäße Verfahren ermöglicht eine genaue Auftrennung von flächenhaft verbundenen Materialkomponenten bei einem Bedarfsgegenstand durch ein gezieltes Zerlegen der einzelnen Komponenten oder Komponentengruppen, die nach deren Auftrennung dem Recyclingkreislauf zugeführt werden können. Zur Trennung der Materialkomponenten des Bedarfsgegenstands wird erfindungsgemäß ein längliches Schneidelement, vorzugsweise in Form eines Schneiddrahts oder einer Schneidschnur, bereitgestellt. Vorzugsweise handelt es sich um ein dünnes, linienförmiges, biegeschlaffes Schneidelement, das unter Anwendung von über die Enden eingeleitete Kräfte und Bewegungen angetrieben wird und hierdurch das Trennen bewirkt.

Das erfindungsgemäße Verfahren ist dadurch gekennzeichnet, dass zunächst eine Kopplung des Schneidelements mit einer Trenneinrichtung erfolgt. Die Ankopplung erfolgt hierbei vorzugsweise an einer beliebigen Stelle des Schneidelements. In einer bevorzugten Ausführungsvariante erfolgt die Ankopplung des Schneidelements an wenigstens einem Ende. In einer alternativen Ausführungsform erfolgt die Ankopplung des Schneidelements an die Trenneinrichtung vorzugsweise an den beiden Enden des länglichen Schneidelementes. Die hier erwähnten "Enden" des Schneidelements definieren dessen Endbereiche. Je nach Art der Trenneinrichtung kann die Ankopplung jedoch auch an einer anderen Stelle erfolgen, beispielsweise mittig. Jedoch ist eine außermittige Ankopplung an einer beliebigen Stelle die übliche praxisnahe Variante und insofern bevorzugt.

Bedarfsweise kann das Schneidelement in Längsrichtung gestreckt werden, um eine saubere Trennlinie oder Trennfläche zu erzeugen. Die Trenneinrichtung ist zur Führung des Schneidelements entlang einer vordefinierten Schnittlinie quer zur Längsachse des Schneidelements ausgelegt. Vorzugsweise wird die Schnittlinie so gelegt, dass eine möglichst eindeutige Materialtrennung der zu trennenden Materialkomponenten erfolgt. In einem weiteren Verfahrensschritt wird eine Relativbewegung zwischen Schneidelement und Trenngut durchgeführt. Vorzugsweise wird hierfür das Schneidelement in Schnittrichtung entlang der Schnittlinie quer zur Längsachse des Schneidelements bewegt, wobei eine Trennung linienförmig in den Verbindungsebenen der flächenhaft verbundenen Materialkomponenten erfolgt. Durch diese Vorschubbewegung wird eine genau definierte Trennfläche geschaffen, so dass anschließend ein Abtrennen der Materialkomponenten entlang der Schnittlinie erfolgen kann. Unterschiedliche Beschaffenheiten, z.B. Härten, der Materialkomponenten können genutzt werden, die Führung der Schneidelemente zu unterstützen. Mit Hilfe des Schneidelements ist es somit beispielsweise möglich, einen Schuh als Bedarfsgegenstand derart aufzutrennen, dass eine Separation des Oberschuhs oder Brandsohle von der Laufsohle erfolgen kann, insbesondere wenn diese flächig miteinander verbunden sind, wie dies regelmäßig bei gängigen Schuhmodellen der Fall ist.

Das erfindungsgemäße Verfahren ist nicht nur zur Anwendung bei Schuhen beschränkt, sondern auf alle Bedarfsgegenstände anwendbar, bei denen sich die Komponenten an den Verbindungslinien sowie den Verbindungsflächen mit dem länglichen Schneidelement trennen lassen. Vorzugsweise handelt es sich bei dem erfindungsgemäß eingesetzten Schneidelement um einen Draht, einen Faden oder eine Schnur mit einem vorzugsweise kreisförmigen Querschnitt, in anderen Varianten auch quadratischen Querschnitt oder rechteckigen Querschnitt. Vorzugsweise besteht der Schneiddraht aus Metall, Kunststoff oder Textil. Der Schneiddraht kann beispielsweise ein textiler Faden oder eine Nylonschnur sein. Jedoch sind auch andere Materialien oder Materialzusammensetzungen denkbar, die eine Materialauftrennung ermöglichen, beispielsweise Schneidelemente aus Kohlenfaserstoffen, Verbundstoffen oder Keramiken.

Die Auftrennung der Materialkomponenten oder Komponentengruppen erfolgt vorzugsweise durch die quer zur Längsachse des Schneidelements gerichtete Vorschubbewegung des Schneidelements. Die Richtung der Bewegungskraft kann hierbei nicht nur nach in der Ebene nach vorne oder hinten erfolgen, sondern auch nach oben oder unten, d.h. es ist auch möglich, eine Materialkomponenten von der anderen abzuziehen ohne diese durchschneiden zu müssen.

Bei bestimmten Materialien bzw. Materialkomponenten wird eine Auftrennung verbessert, indem das Schneidelement erhitzt wird. Vorzugsweise handelt es sich bei dem Schneidelement daher um einen leitfähigen, beispielsweise metallischen Schneiddraht, der über eine elektrische Heizeinrichtung beheizt wird. Ein elektrischer Heizstrom sorgt dafür, dass sich der Schneiddraht erhitzt, um die Trennwirkung bei bestimmten Materialverbünden (z.B. Thermoplasten) zu verstärken. Vorzugsweise ist das Schneidelement deshalb elektrisch leitfähig. Die Einkopplung der Heizströme in die aktiv schneidende Strecke der Schneiddrähte kann über Klemmen bei fest eingeklemmten Schneiddrähten oder elektrisch leitfähigen Rollen bei alternierenden Umwickelvorrichtungen erfolgen. Über die spezifischen Widerstände des Schneidelements und die Höhe der Stromstärke kann die elektrische Heizwirkung variabel auf einen Sollwert eingestellt werden.

Um die Schnittwirkung zu erhöhen, ist in einer bevorzugten Ausführungsvariante vorgesehen, dass das Schneidelement bei seiner Bewegung entlang der Schnittlinie zusätzlich eine gleichgerichtete oder oszillierende Bewegung entlang seiner Längsachse durchführt. In Kombination mit einer elektrischen Beheizung des Schneidelements wird dadurch eine optimale Trennwirkung erzielt, was beispielsweise bei thermoplastischen Materialien dazu führt, dass geringere Trennkräfte erforderlich sind. Eine lineare Bewegung wird beispielsweise dadurch verwirklicht, dass das Kopplungselement oder die Kopplungselemente als Spulen ausgeführt sind, mit denen es möglich ist, das Schneidelement in Form eines Schneiddrahtes aufzuwickeln bzw. abzuwickeln. Dazu kann erfindungsgemäß eine alternierende Umwickelvorrichtung oder ein oszillierender Drahtbügel mit gespanntem Schneiddraht vorgesehen sein.

Die Schnittlinie wird bei dem erfindungsgemäßen Verfahren zuvor festgelegt, wobei zusätzliche Rückkopplungssysteme, wie z.B. Sensoren, bildgebende Kamerasysteme, Kraftmesszellen oder Drahtbruchüberwachungssysteme, die Vorschubbewegung und damit die Schnittbewegung kontrollieren und bei Bedarf anpassen können. In einer weiterentwickelten Variante ist es auch möglich, die Trennkräfte und damit die Trennwirkung anzupassen, um so den erwünschten Trennerfolg herbeizuführen. Dies kann beispielsweise durch eine gezielte Anpassung der Oszillationsfrequenz des länglichen Schneidelements erfolgen. In einer weiterentwickelten Variante wird das Verfahren automatisiert durchgeführt, d.h. die einzelnen Komponenten werden aufgetrennt und entsprechend ihrer Materialzusammensetzung gesammelt und dem späteren Wiederverwertungskreislauf zugeführt.

In einer bevorzugten Variante des erfindungsgemäßen Verfahrens ist das Schneidelement bereits als Teil des Herstellungsprozesses fest in den Bedarfsgegenstand integriert, so dass lediglich eine Ankopplung an eine Trenneinrichtung über die Enden des Schneidelements erfolgen muss. Das erfindungsgemäße Verfahren ist in dieser Variante so ausgelegt, um solche, mit einem inneren Schneidelement ausgerüstete Bedarfsgegenstände effizient zu zerlegen und dem Recycling zuzuführen. Vorzugsweise ist das innere Schneidelement so in dem Bedarfsgegenstand integriert, dass eine Kopplung an die Trenneinrichtung erfolgen kann. Das in dem Bedarfsgegenstand integrierte Schneidelement wird in dem Gegenstand so positioniert, dass eine Trennfläche entsteht, wenn sich das Schneidelement im Laufe des Trennvorgangs hindurchbewegt, um die Materialkomponenten zu trennen. Die Trenneinrichtung koppelt nicht nur das Schneidelement, sondern generiert auch die Relativbewegungen zwischen Trenngut und Schneidelement, um dieses linienförmig durch die Verbindungsflächen der Materialkomponenten zu führen.

Die Erfindung betrifft ferner eine Vorrichtung zum Recyceln von Bedarfsgegenständen, insbesondere von Schuhen, die zumindest teilweise aus flächenhaft verbundenen Materialkomponenten aufgebaut sind. Die Vorrichtung umfasst ein Halteelement, das zur Aufnahme und zum Halten des Bedarfsgegenstandes dient. Bei dem Halteelement kann es sich beispielsweise um einen Greifer, eine Plattform, eine Auflagefläche oder ein Stützelement handeln. Die Vorrichtung umfasst ferner ein längliches Schneidelement, das in Schnittrichtung entlang einer vordefinierten Schnittlinie quer zur Längsachse des Schneidelements bewegbar ist. Schließlich umfasst die Vorrichtung auch wenigstens ein Kopplungselement, vorzugsweise zwei über einen Träger verbundene Kopplungselemente, die das Schneidelement an einer Stelle, vorzugsweise an einem oder beiden Enden einspannen und so ausgelegt sind, dass bedarfsweise entlang der Schnittlinie zusätzlich eine gleich gerichtete oder oszillierende Bewegung entlang seiner Längsachse möglich ist. Vorzugsweise sind die beiden Kopplungselemente der Trenneinrichtung so ausgestaltet, dass das Schneidelement zumindest teilweise aufgewickelt oder abgewickelt werden kann.

Die Vorschubbewegung entsprechend der vorliegenden Erfindung ist als Relativbewegung des Schneidelements quer zu dessen Längsachse zum Trenngut zu verstehen. Vorzugsweise wird diese Bewegung von einem Roboter oder einer CNC-Maschine umgesetzt. In einer weiteren Ausführungsform umfasst die Vorrichtung eine elektrische Heizeinrichtung, um das Schneidelement, in Verbindung mit der Heizwirkung der Schnittbewegungen, auf eine gewünschte, materialabhängige Temperatur zwischen 50°C und 350°C, bevorzugt zwischen 100°C und 200°C zu erhitzen. Die Kopplungselemente haben vorzugsweise einen kreisförmigen Querschnitt. Bevorzugt sind diese so ausgestaltet, dass bei einer oszillierenden oder linearen Bewegung des Schneidelements eine partielle Aufwicklung oder Abwicklung des Schneidelements erfolgt.

In einer bevorzugten Ausführungsvariante der Erfindung ist das längliche Schneidelement bereits fest in dem Bedarfsgegenstand integriert, so dass lediglich eine Ankopplung des Schneidelements (z.B. in Form eines Schneiddrahts) ein einer Stelle, vorzugsweise an wenigstens einem Ende, vorzugsweise an beiden Enden des Schneidelements, an die Kopplungselemente der Trenneinrichtung erfolgen muss. Beispielsweise wird bei der Schuhproduktion bereits ein Schneiddraht beim Herstellungsprozess eingearbeitet, um so eine gezielte Zerlegung des Schuhs für den Zweck des Recyclings umzusetzen. Die Position und Lage des in dem Bedarfsgegenstand integrierten Schneidelements, d.h. des inneren Schneidelements, können so gewählt werden, dass vordefinierte Schnittlinien bzw. Trennlinien erzeugt werden. Durch diese Festlegung wird eine optimale Materialtrennung erreicht. Bedarfsweise müssen die Enden des in dem Bedarfsgegenstand integrierten Schneidelementes zunächst freigelegt werden, damit eine Ankopplung der Enden an die Trenneinrichtung erfolgen kann.

Die vorliegende Erfindung betrifft ferner einen Bedarfsgegenstand, vorzugsweise Schuh, der mit einem erfindungsgemäßen Schneidelement ausgerüstet ist. Der erfindungsgemäße Bedarfsgegenstand besteht aus wenigstens einem Materialverbund, wobei in einer Materialschicht des Bedarfsgegenstands ein längliches Schneidelement integriert ist, das so konfiguriert ist, dass es entlang einer Schnittlinie quer zu Längsachse des Schneidelements linienförmig in den Verbindungsebenen der flächenhaft verbundenen Materialkomponenten bewegbar ist.

Wie jeder Schuh umfasst der erfindungsgemäße Schuh ein Oberteil, auch Schaftgenannt, und eine Laufsohle mit vorzugsweise einer Hinterkappe und einer Vorderkappe. Der erfindungsgemäße Schuh ist jedoch dadurch gekennzeichnet, dass in einer Materialschicht des Schuhs ein längliches Schneidelement integriert ist, das so konfiguriert ist, dass es entlang der Schnittlinie quer zur Längsachse des Schneidelements bewegbar ist. Das längliche Schneidelement ist vorzugsweise so in den Schuh integriert dass eine Abtrennung von zwei unterschiedlichen Materialkomponenten erfolgen kann, bevorzugt eine Abtrennung der Laufsohle vom Schaft oder von der Brandsohle. Die Positionierung des Schneidelements kann aber auch derart erfolgen, dass zwei Schaftteile voneinander getrennt werden, oder eine Kappe vom Schaft oder der Sohle getrennt werden kann.

Vorzugsweise ist wenigstens ein Stück des Schneidelements, vorzugsweise die beiden Enden des Schneidelements, mit einem oder mehreren Kopplungselementen einer erfindungsgemäßen Trenneinrichtung verbindbar. In einer weiteren Ausführungsvariante ist vorgesehen, dass die Enden des Schneidelements zur Verbesserung der Ankopplung an die Trenneinrichtung als Schlaufen ausgebildet sind. Das in dem Bedarfsgegenstand integrierte Schneidelement besteht vorzugsweise aus Metall, Kunststoff oder Textil.

Die Erfindung wird in den nachfolgenden Ausführungsbeispielen näher erläutert. Es zeigen:
- Fig. 1: die Arbeitsweise des erfindungsgemäßen Verfahrens am Beispiels eines Schuhs als Bedarfsgegenstand,
- Fig. 2: eine alternative Variante zur Auftrennung eines Schuhs mit einem Materialverbund,
- Fig. 3: die Trennung von Materialkomponenten mit einer Trenneinrichtung entlang einer Schnittlinie,
- Fig. 4: die aufgetrennten Materialkomponenten am Ende des Trennschrittes gemäß Fig. 3,
- Fig. 5: einen mit einem Schneidelement ausgerüsteten Schuh,
- Fig. 6: den mit dem Schneidelement ausgerüsteten Schuh von dessen Unterseite.

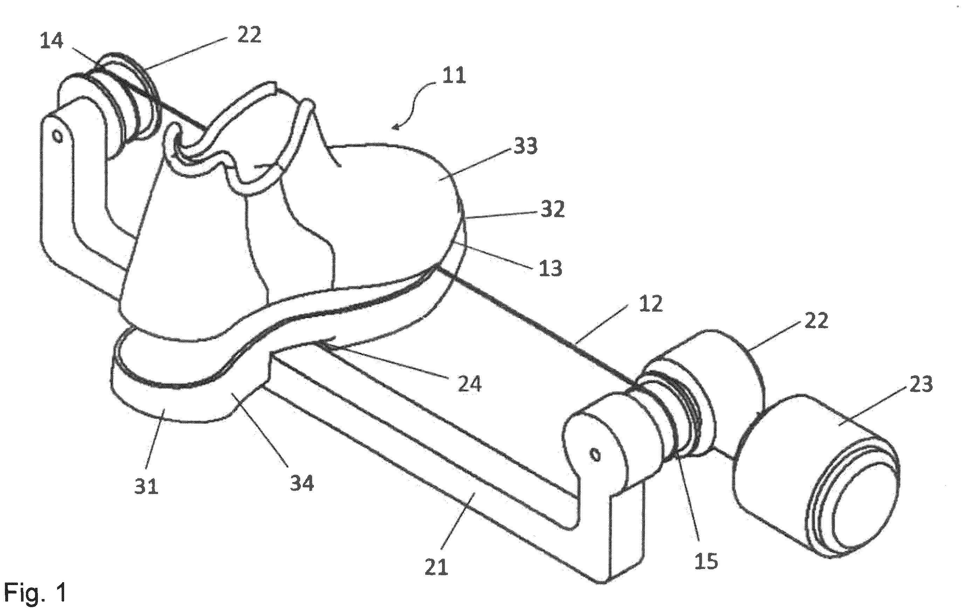

In Fig. 1 ist eine Variante des erfindungsgemäßen Verfahrens zum Recyceln von Bedarfsgegenständen 11 und eine hierfür entwickelte Vorrichtung gezeigt. Zu erkennen ist eine Trenneinrichtung 21 mit einem Halteelement 24 zur Aufnahme und zum Halten des Bedarfsgegenstandes 11. Die Trenneinrichtung 21 umfasst in der gezeigten Ausführungsvariante zwei Kopplungselemente 22, welche die Enden 14, 15 des Schneidelements 12 aufnehmen und somit für dessen Ankopplung sorgen. In einer hier nicht gezeigten Variante kann die Ankopplung auch an einem einzigen Kopplungselement 22 erfolgen. Das Schneidelement 12 besteht in der gezeigten Ausführungsform aus einem beheizbaren metallischen Schneiddraht. Bei dem Bedarfsgegenstand 11 handelt es sich um einen Schuh, bestehend aus einem Oberschuh 33 mit Vorderkappe 32 und Hinterkappe 31 sowie einer Laufsohle 34. Das Beispiel zeigt die Trennung des Oberschuhs 33 von der Laufsohle 34 anhand einer Schnittlinie 13 durch das längliche Schneidelement 12. Dazu wird das Schneidelement 12 quer zur Längsrichtung des Schneidelements 12 geführt, so dass eine wohldefinierte Trennfläche zwischen den Materialkomponenten des Oberschuhs 33 und der Laufsohle 34 entsteht. Zusätzlich kann das Schneidelement 12 linear oder oszillierend bewegt werden. Hierfür ist eine Antriebseinheit 23 vorgesehen, über welche die Kopplungselemente 22 rotiert werden können. Diese Kopplungselemente 22 sind als Umlenkspulen für den Schneiddraht ausgelegt.

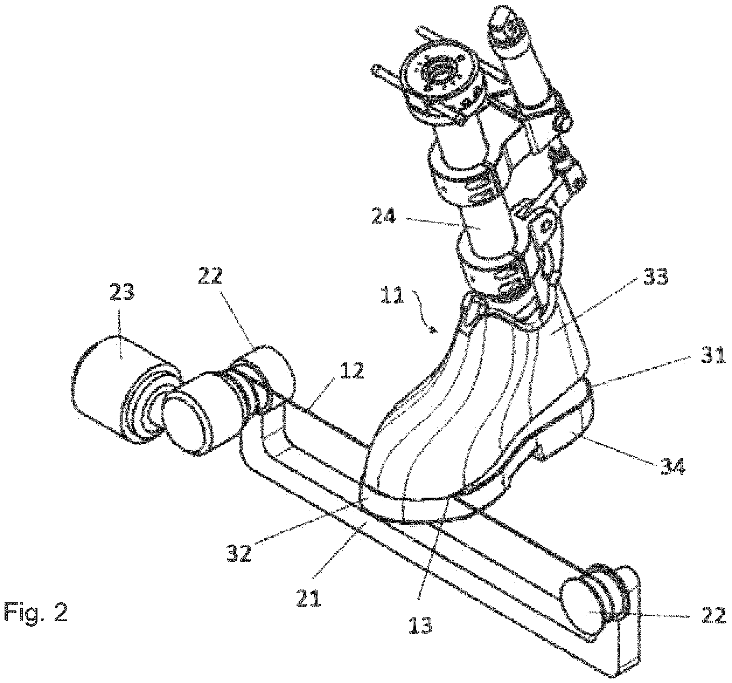

In Fig. 2 ist eine weitere Ausführungsvariante gezeigt, bei der das Halteelement 24 in den Bedarfsgegenstand 11 eingeführt wird und diesen zur Trennung der Komponenten oder Komponentengruppen durch das Schneidelement 12 in Position hält. Auch hier erfolgt der Vorschub des Schneidelements 12 quer zu dessen Längsachse entlang der Schnittlinie 13.

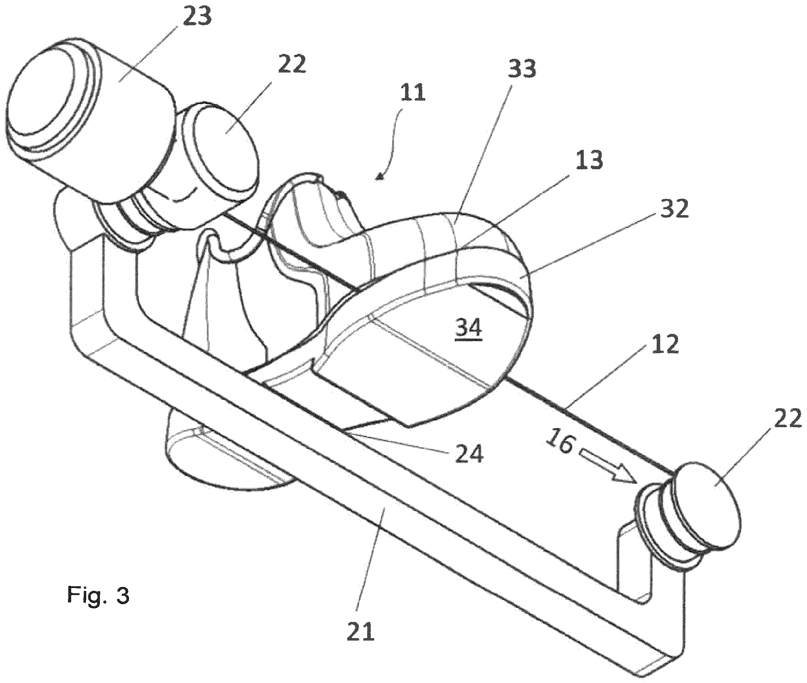

In Fig. 3 ist eine weitere Perspektive von der Unterseite zu sehen. Entlang der Schnittlinie 13 wird der Oberschuh 33 von der Laufsohle 34 durch das Schneidelement 12 getrennt.

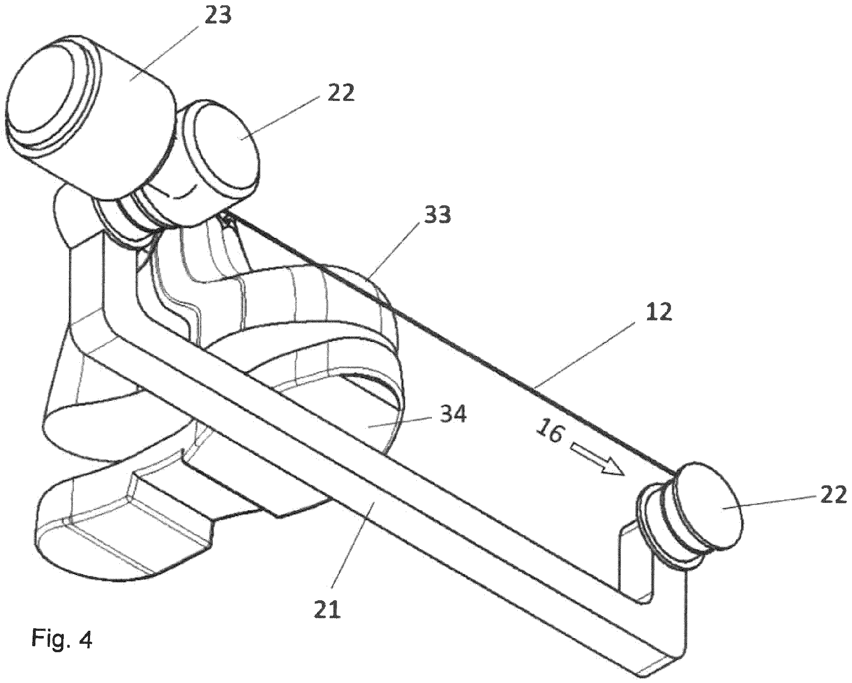

In Fig. 4 sind die getrennten Materialkomponenten gezeigt, so dass der Oberschuh 33 und die Laufsohle 34 unterschiedlichen Recyclingkreisläufen zugeführt werden können.

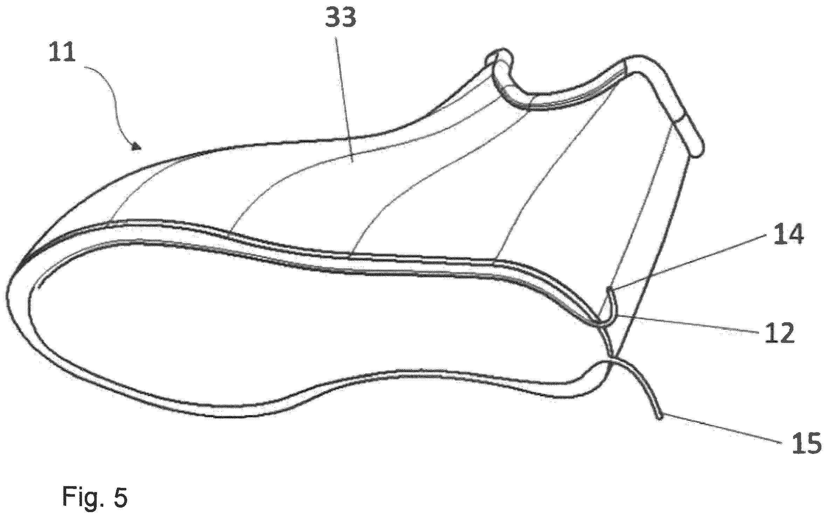

In Fig. 5 ist ein Schuh als Bedarfsgegenstand 11 gezeigt, bei dem bereits ein längliches Schneidelement 12 im Herstellungsprozess integriert ist. Für das spätere Recycling müssen lediglich die Enden 14, 15 des Schneidelements 12 mit einer Trenneinrichtung verbunden werden. Gegebenenfalls müssen die Enden 14, 15 des Schneidelements 12 für den Recyclingprozess freigelegt werden.

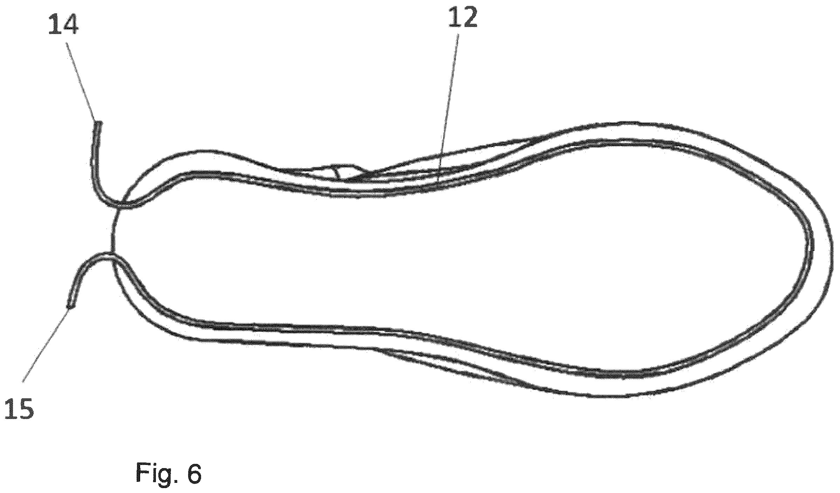

In Fig. 6 ist die in Fig. 5 gezeigte Variante nochmals von der Unterseite zu sehen. Bei dem Schneidelement 12 handelt es sich vorzugsweise um einen dünnen Draht oder Kunststofffaden, der in das Material des Bedarfsgegenstandes 11 eingearbeitet ist. Die Enden 14, 15 des Schneidelements 12 können über Werkzeuge, beispielsweise Greifer oder andere Kopplungselemente mit einer Trenneinrichtung verbunden werden. Das Schneidelement 12 wird dann durch Anwendung von Kraft und Bewegung durch die zu trennenden Schichten bewegt. Die Steuerung der Bewegung der Schneidelemente 12 kann hierbei aktiv über Bahnsteuerung von externen Führungs- und Bewegungselementen erfolgen, oder über die Bedarfsgegenstände 11 selbst, beispielsweise durch eine Führung der Schneidelemente 12 durch die weiche Laufsohle oder über die steife Brandsohle des Schuhs. Auch eine Kombination aus beiden ist möglich. Maßgeblich ist letztlich eine Relativbewegung zwischen dem Bedarfsgegenstand 11 bzw. dem Trenngut und den Schneidelementen 12.

Die Enden 14, 15 des Schneidelements 12 können in die Sohle eingespritzt oder eingeklebt sein. Vorzugsweise sind die Enden 14, 15 als Schlaufen in die Sohle eingespritzt oder eingeklebt.

Durch ein geeignetes Platzieren der integrierten Schneidelemente 12 lassen sich Fügeverbindungen gezielt lösen oder Schichten von Materialverbünden voneinander trennen.

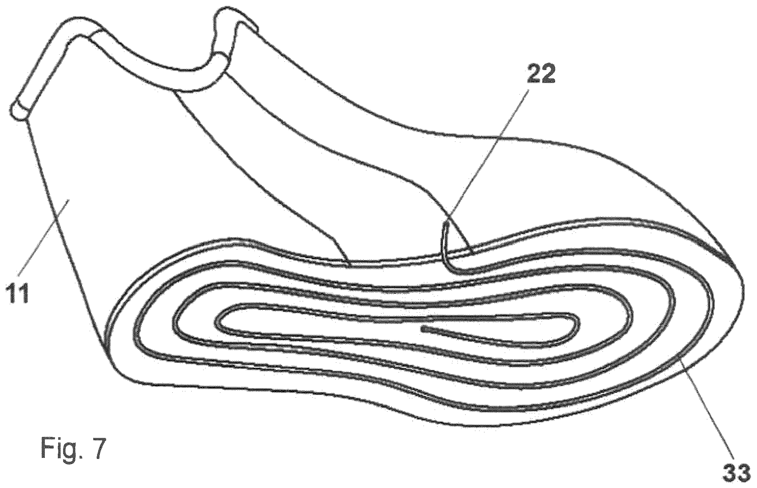

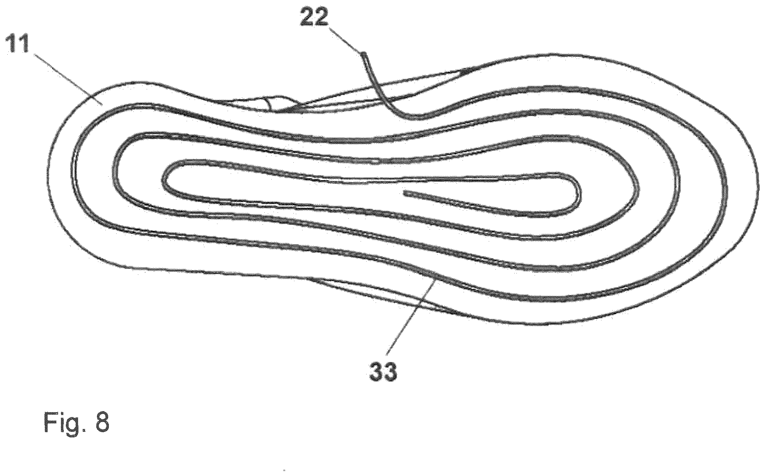

In den Fig. 7 und 8 ist ein Schuh, als Beispiel eines Bedarfsgegenstands 11 mit einem darin angeordneten integrierten länglichen Schneidelement 22 gezeigt, das spulenförmig im Oberschuh 33 eingebracht ist. Die Ankopplung des Schneidelements 22 an eine Trenneinrichtung zur Auftrennung der Materialkomponenten erfolgt bei dieser Ausführungsvariante lediglich an einem Ende des Schneidelements 22.

Nicht immer wird es erforderlich sein, eine Schnittbewegung der Schneiddrähte durchzuführen. Bei geeigneten Fügeverbindungen kann auch ein Abziehen der Schneiddrähte mit einer Komponente senkrecht zur Nahtlinie mit ausreichender Kraft ausreichen, um die Fügeverbindung aufzutrennen oder die Materialstruktur aufzubrechen. Es können durch solche inneren Schneidelemente 12, die von Fügenähten eingefasst sind, auch Nähte aufgetrennt werden, indem die Schneidelemente 12 entlang der Nähte nach außen abgezogen werden und die Nähte aufschneiden oder aufreißen. Ähnlich lassen sich auch gezielt Klebestellen auftrennen, indem ein inneres Schneidelement 12 mit eingeklebt wird.

Die Erfindung umfasst ferner verschiedene Kombinationen der hier gezeigten Ausführungsvarianten oder auch Kombinationen von Merkmalen einzelner Ausführungsformen. Keinesfalls ist die Erfindung auf die hier beschriebenen Varianten beschränkt.

## Patentansprüche

1. Verfahren zum Recycling von Bedarfsgegenständen (11), die zumindest teilweise aus flächenhaft verbundenen Materialkomponenten (33, 34) aufgebaut sind, durch Zerlegen der Bedarfsgegenstände (11) in einzelne Materialkomponenten oder Komponentengruppen, wobei zur Trennung der Materialkomponenten des Bedarfsgegenstands ein längliches Schneidelement (12) bereitgestellt wird, **gekennzeichnet durch** die Schritte:
- Kopplung des Schneidelements (12) mit einer Trenneinrichtung (21), die zur Führung des Schneidelements (12) entlang einer vordefinierten Schnittlinie (13) ausgelegt ist,
- Bewegen des Schneidelements (12) in Schnittrichtung entlang der Schnittlinie (13) quer zur Längsachse (16) des Schneidelements (12), wobei eine linienförmige Trennung in den Verbindungsebenen der flächenhaft verbundenen Materialkomponenten (33, 34) erfolgt,
- Abtrennen der Materialkomponenten entlang der durch die Schnittlinie (13) entstehenden Trennfläche.

2. Verfahren nach Anspruch 1, **dadurch gekennzeichnet, dass** das Schneidelement (12) einen kreisförmigen Querschnitt, quadratischen Querschnitt oder rechteckigen Querschnitt aufweist.

3. Verfahren nach Anspruch 1 oder 2, **dadurch gekennzeichnet, dass** es sich bei dem Schneidelement (12) um einen Draht, einen Faden oder eine Schnur handelt.

4. Verfahren nach einem der Ansprüche 1 bis 3, **dadurch gekennzeichnet, dass** das Schneidelement (12) bei seiner Bewegung entlang der Schnittlinie (13) zusätzlich eine gleichgerichtete oder oszillierende Bewegung entlang seiner Längsachse (16) durchführt.

5. Verfahren nach einem der Ansprüche 1 bis 4, **dadurch gekennzeichnet, dass** es sich bei dem Schneidelement (12) um einen elektrisch leitfähigen Schneiddraht oder Schneidfaden handelt, der über eine elektrische Heizeinrichtung beheizt wird.

6. Verfahren nach einem der Ansprüche 1 bis 5, **dadurch gekennzeichnet, dass** die Ankopplung des Schneidelements (12) an die Trenneinrichtung (21) an wenigstens einer Stelle, vorzugsweise an einem oder mehreren Enden (14, 15) erfolgt.

7. Verfahren nach einem der Ansprüche 1 bis 6, **dadurch gekennzeichnet, dass** es sich bei dem Bedarfsgegenstand (11) um einen Schuh handelt, bei dem das Schneidelement (12) mit zwei Enden (14, 15) bereits im Schuh integriert ist, wobei das Schneidelement (12) so ausgelegt ist, dass
a) eine Ankopplung an das Schneidelement (12) an wenigstens einer Stelle, vorzugsweise an einem oder mehreren Enden (14, 15), an die Trenneinrichtung (21) erfolgt, und
b) eine Vorschubbewegung des Schneidelements (12) entlang der vordefinierten Schnittlinie (13) quer zur Längsachse (16) des Schneidelements (12) möglich ist.

8. Vorrichtung zum Recycling von Bedarfsgegenständen (11), die zumindest teilweise aus flächenhaft verbundenen Materialkomponenten (33, 34) aufgebaut sind, umfassend
- ein Halteelement (24), das zur Aufnahme und zum Halten des Bedarfsgegenstands (11) ausgelegt ist,
- ein längliches Schneidelement (12), das in Schnittrichtung entlang einer vordefinierten Schnittlinie (13) quer zur Längsachse (16) des Schneidelements (12) bewegbar ist, und das so konfiguriert ist, dass eine linienförmige Trennung in den Verbindungsebenen der flächenhaft verbundenen Materialkomponenten (33, 34) erfolgt, und
- wenigstens ein über einen Querträger verbundenes Kopplungselement (22) zur Einspannung des Schneidelements (12) an wenigstens einem Ende (14, 15), wobei das wenigstens eine Kopplungselement (22) so ausgelegt ist, dass bedarfsweise entlang der Schnittlinie (13) zusätzlich eine gleichgerichtete oder oszillierende Bewegung entlang seiner Längsachse (16) erfolgt.

9. Vorrichtung nach Anspruch 8, **dadurch gekennzeichnet, dass** zusätzliche eine elektrische Heizeinrichtung zur Erhitzung des Schneidelements (12) vorgesehen ist.

10. Vorrichtung nach Anspruch 8 oder 9, **dadurch gekennzeichnet, dass** die Vorschubbewegung des Schneidelements (12) entlang der vordefinierten Schnittlinie (13) quer zur Längsachse (16) des Schneidelements (12) über einen Roboter oder eine CNC-Maschine erfolgt.

11. Vorrichtung nach einem der Ansprüche 1 bis 10, **dadurch gekennzeichnet, dass** das wenigstens eine Kopplungselement (22) einen kreisförmigen Querschnitt aufweist.

12. Bedarfsgegenstand (11), bestehend aus wenigstens einem Materialverbund, **dadurch gekennzeichnet, dass** in einer Materialschicht des Bedarfsgegenstands (11) ein längliches Schneidelement (12) integriert ist, das so konfiguriert ist, dass es entlang einer Schnittlinie (13) quer zu Längsachse (16) des Schneidelements (12) linienförmig in den Verbindungsebenen der flächenhaft verbundenen Materialkomponenten bewegbar ist.

13. Bedarfsgegenstand (11) nach Anspruch 12, wobei es sich um einen Schuh handelt, umfassend einen Oberschuh (33), eine Laufsohle (34), eine Hinterkappe (31) und eine Vorderkappe (32), wobei das längliche Schneidelement (2) so integriert ist, dass eine Abtrennung von zwei unterschiedlichen Materialkomponenten erfolgen kann.

14. Bedarfsgegenstand (11) nach Anspruch 12 oder 13, **dadurch gekennzeichnet, dass** wenigstens ein Ende (14, 15) des Schneidelements (12) als Schlaufe ausgebildet ist, die an eine Trenneinrichtung koppelbar ist.

15. Bedarfsgegenstand (11) nach einem der Ansprüche 12 bis 14, **dadurch gekennzeichnet, dass** das in den Bedarfsgegenstand (11) integrierte Schneidelement (12) aus Metall, Kunststoff oder Textil besteht.

## Geänderte Patentansprüche

### Geänderte Patentansprüche gemäss Regel 137(2) EPÜ.

1. Verfahren zum Recycling von Bedarfsgegenständen (11), die zumindest teilweise aus flächenhaft verbundenen Materialkomponenten (33, 34) aufgebaut sind, durch Zerlegen der Bedarfsgegenstände (11) in einzelne Materialkomponenten oder Komponentengruppen, wobei zur Trennung der Materialkomponenten des Bedarfsgegenstands ein längliches Schneidelement (12) bereitgestellt wird, **gekennzeichnet durch** die Schritte:
- Kopplung des Schneidelements (12) mit einer Trenneinrichtung (21), die zur Führung des Schneidelements (12) entlang einer vordefinierten Schnittlinie (13) ausgelegt ist,
- Bewegen des Schneidelements (12) in Schnittrichtung entlang der Schnittlinie (13) quer zur Längsachse (16) des Schneidelements (12), wobei eine linienförmige Trennung in den Verbindungsebenen der flächenhaft verbundenen Materialkomponenten (33, 34) erfolgt,
- Abtrennen der Materialkomponenten entlang der durch die Schnittlinie (13) entstehenden Trennfläche, **dadurch gekennzeichnet, dass** das Schneidelement (12) bei seiner Bewegung entlang der Schnittlinie (13) zusätzlich eine gleichgerichtete oder oszillierende Bewegung entlang seiner Längsachse (16) durchführt.

2. Verfahren nach Anspruch 1, **dadurch gekennzeichnet, dass** das Schneidelement (12) einen kreisförmigen Querschnitt, quadratischen Querschnitt oder rechteckigen Querschnitt aufweist.

3. Verfahren nach Anspruch 1 oder 2, **dadurch gekennzeichnet, dass** es sich bei dem Schneidelement (12) um einen Draht, einen Faden oder eine Schnur handelt.

4. Verfahren nach einem der Ansprüche 1 bis 3, **dadurch gekennzeichnet, dass** es sich bei dem Schneidelement (12) um einen elektrisch leitfähigen Schneiddraht oder Schneidfaden handelt, der über eine elektrische Heizeinrichtung beheizt wird.

5. Verfahren nach einem der Ansprüche 1 bis 4, **dadurch gekennzeichnet, dass** die Ankopplung des Schneidelements (12) an die Trenneinrichtung (21) an wenigstens einer Stelle, vorzugsweise an einem oder mehreren Enden (14, 15) erfolgt.

6. Verfahren nach einem der Ansprüche 1 bis 5, **dadurch gekennzeichnet, dass** es sich bei dem Bedarfsgegenstand (11) um einen Schuh handelt, bei dem das Schneidelement (12) mit zwei Enden (14, 15) bereits im Schuh integriert ist, wobei das Schneidelement (12) so ausgelegt ist, dass
a) eine Ankopplung an das Schneidelement (12) an wenigstens einer Stelle, vorzugsweise an einem oder mehreren Enden (14, 15), an die Trenneinrichtung (21) erfolgt, und
b) eine Vorschubbewegung des Schneidelements (12) entlang der vordefinierten Schnittlinie (13) quer zur Längsachse (16) des Schneidelements (12) möglich ist.

7. Vorrichtung zum Recycling von Bedarfsgegenständen (11), die zumindest teilweise aus flächenhaft verbundenen Materialkomponenten (33, 34) aufgebaut sind, umfassend
- ein Halteelement (24), das zur Aufnahme und zum Halten des Bedarfsgegenstands (11) ausgelegt ist,
- ein längliches Schneidelement (12), das in Schnittrichtung entlang einer vordefinierten Schnittlinie (13) quer zur Längsachse (16) des Schneidelements (12) bewegbar ist, und das so konfiguriert ist, dass eine linienförmige Trennung in den Verbindungsebenen der flächenhaft verbundenen Materialkomponenten (33, 34) erfolgt, und
- wenigstens ein über einen Querträger verbundenes Kopplungselement (22) zur Einspannung des Schneidelements (12) an wenigstens einem Ende (14, 15), wobei das wenigstens eine Kopplungselement (22) so ausgelegt ist, dass bedarfsweise entlang der Schnittlinie (13) zusätzlich eine gleichgerichtete oder oszillierende Bewegung entlang seiner Längsachse (16) erfolgt.

8. Vorrichtung nach Anspruch 7, **dadurch gekennzeichnet, dass** zusätzliche eine elektrische Heizeinrichtung zur Erhitzung des Schneidelements (12) vorgesehen ist.

9. Vorrichtung nach Anspruch 7 oder 8, **dadurch gekennzeichnet, dass** die Vorschubbewegung des Schneidelements (12) entlang der vordefinierten Schnittlinie (13) quer zur Längsachse (16) des Schneidelements (12) über einen Roboter oder eine CNC-Maschine erfolgt.

10. Vorrichtung nach einem der Ansprüche 1 bis 9, **dadurch gekennzeichnet, dass** das wenigstens eine Kopplungselement (22) einen kreisförmigen Querschnitt aufweist.

11. Bedarfsgegenstand (11), bestehend aus wenigstens einem Materialverbund, **dadurch gekennzeichnet, dass** in einer Materialschicht des Bedarfsgegenstands (11) ein längliches Schneidelement (12) integriert ist, das so konfiguriert ist, dass es entlang einer Schnittlinie (13) quer zu Längsachse (16) des Schneidelements (12) linienförmig in den Verbindungsebenen der flächenhaft verbundenen Materialkomponenten bewegbar ist.

12. Bedarfsgegenstand (11) nach Anspruch 11, wobei es sich um einen Schuh handelt, umfassend einen Oberschuh (33), eine Laufsohle (34), eine Hinterkappe (31) und eine Vorderkappe (32), wobei das längliche Schneidelement (2) so integriert ist, dass eine Abtrennung von zwei unterschiedlichen Materialkomponenten erfolgen kann.

13. Bedarfsgegenstand (11) nach Anspruch 11 oder 12, **dadurch gekennzeichnet, dass** wenigstens ein Ende (14, 15) des Schneidelements (12) als Schlaufe ausgebildet ist, die an eine Trenneinrichtung koppelbar ist.

14. Bedarfsgegenstand (11) nach einem der Ansprüche 11 bis 13, **dadurch gekennzeichnet, dass** das in den Bedarfsgegenstand (11) integrierte Schneidelement (12) aus Metall, Kunststoff oder Textil besteht.
